# DEMANDE DE BREVET EUROPEEN

(11) **EP 2 458 657 A1**
(43) Date de publication de la demande: **30.05.2012**
(21) Numéro de dépôt: 11354052.0
(22) Date de dépôt: 11.10.2011
(51) Int. Cl.: H01L 35/32

(54) **Module thermoélectrique à rendement améliore**

(30) Priorité: 26.11.2010 FR 1004595
(71) Demandeur: Schneider Electric Industries SAS, 92500 Rueil-Malmaison (FR)
(72) Inventeur: Caillault, Nathalie, 38050 Grenoble Cedex 09 (FR); Giroud, Cédric, 38050 Grenoble Cedex 09 (FR); Aymami, Joan, 38050 Grenoble Cedex 09 (FR)
(74) Mandataire: Picard, Laurent

(57) **Abrégé**

Module thermoélectrique comprenant une matrice comportant des jonctions (10) ayant deux puces thermoélectriques (31, 32) de type N et de type P, lesdites jonctions étant reliées électriquement pour former un circuit électrique. La circulation d'un courant électrique (I) dans le circuit chauffe une face de la matrice par effet Peltier. Le chauffage d'une face de la matrice fait circuler un courant électrique par effet Seebeck. Le module comprend un premier groupe (100) de jonctions (10) de deux puces thermoélectriques (31, 32) de type N et P exposé à une première température de fonctionnement (T1) ; un second groupe (101) de jonctions de deux puces thermoélectriques (31, 32) de type N et P exposé à une seconde température de fonctionnement (T2). La seconde température (T2) est inférieure à la première température (T1) et les deux groupes de jonctions (101, 101) étant séparés par un isolant thermique (50).

## Description

### DOMAINE TECHNIQUE DE L'INVENTION

L'invention est relative à un module thermoélectrique comprenant une matrice comportant des jonctions ayant deux puces thermoélectriques de type N et de type P, lesdites jonctions étant reliées électriquement pour former un circuit électrique. La circulation d'un courant électrique dans le circuit chauffe une face de la matrice par effet Peltier. Le chauffage d'une face de la matrice fait circuler un courant électrique dans le circuit par effet Seebeck.

### ETAT DE LA TECHNIQUE ANTERIEURE

L'utilisation de puces thermoélectriques de type P et N agencées entre elles de manières à créer des convertisseurs d'énergie thermoélectrique est connue.

Tel que représenté sur la figure 1 et tel que décrit dans les demandes de brevet FR2775123, EP1331674, le convertisseur ou module thermoélectrique est adapté pour être maintenu entre une couche inférieure 130 et une couche supérieure 140.

Le convertisseur ou module thermoélectrique M comporte une matrice composé d'au moins une colonne comprenant une alternance de puces thermoélectriques de type P et de type N 31 et 32. Ainsi, deux éléments d'un type sont séparés par un élément de l'autre type.

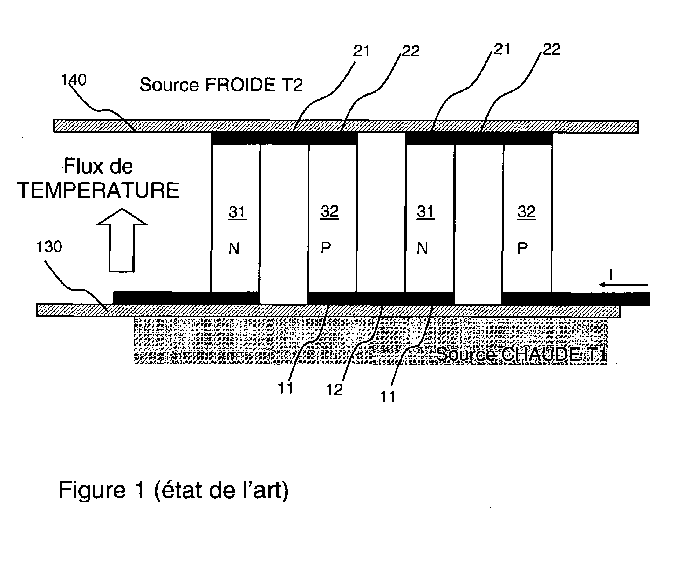

Les puces sont reliées électriquement en série à l'aide de premiers et seconds contacts 11 et 21 respectivement disposés sur des faces opposées des puces. Comme le montre bien la figure 1, chaque électrode 31 de type N est reliée, d'un côté via un premier contact 11, à l'électrode voisine 32 de type P par une piste conductrice 12 disposée sur la couche inférieure 130 et, de l'autre côté via un second contact 21, à son autre l'électrode voisine 32 de type P par une piste conductrice 22 disposée sur la couche supérieure 140. De manière identique, et bien évidemment, chaque électrode 32 de type P est reliée, d'un côté via un premier contact 11, à l'électrode voisine 31 de type N par une piste 12 sur la couche inférieure 130 et, de l'autre côté via un second contact 21, à son autre électrode voisine 31 de type N par une piste 22 sur la couche supérieure 140.

La petite épaisseur et la rigidité de cette structure de composant font que l'écart de température à ses bornes devient faible avec le temps. Si l'écart de température devient faible, le thermo-générateur perd en performance.

Pour conserver un écart de température voulu, il est nécessaire d'associer le convertisseur ou module thermoélectrique à un dispositif échangeur de chaleur. Le dispositif à échangeur de chaleur peut comprendre de préférence une base munie d'ailettes de rayonnement thermique, et un panneau servant de surface d'échange thermique à des fins de refroidissement ou de chauffage.

La présence de ce dispositif à échangeur de chaleur augmente considérablement le volume du produit, le rendant difficilement intégrable dans certains produits.

Une autre solution tel que décrite dans la demande de brevet US2003042497, permet d'augmenter l'efficacité du produit par une gestion habile du gradient de température et par une disposition nouvelle des électrodes. En effet, les électrodes des jonctions sont disposées sous forme de couches minces empilées. Cependant, de part ça faible épaisseur, cette solution est soumis au même problème que précédemment.

### EXPOSE DE L'INVENTION

L'invention vise donc à remédier aux inconvénients de l'état de la technique, de manière à proposer un module thermoélectrique à rendement amélioré.

Le module selon l'invention comprend un premier et second groupes de jonctions séparés l'un de l'autre par un isolant thermique, le premier groupe comprenant au moins une jonction de deux puces thermoélectriques de type N et de type P et le second groupe comprenant au moins une jonction de deux puces thermoélectriques de type N et de type P, les premier et second groupes de jonctions étant exposés respectivement à une première et à une seconde température de fonctionnement. Les deux puces de type N et P d'une jonction sont de forme aplanie pour être empilées sur un substrat isolant par dépôt de couches minces sur un substrat isolant. Au moins une puce de type N d'une première jonction du premier groupe est connectée électriquement avec une puce de type P ou de type N d'une première jonction du second groupe.

Selon un mode de développement de l'invention, au moins une puce de type N d'une première jonction du premier groupe est connectée en série avec une puce de type P d'une première jonction du second groupe pour augmenter la tension.

De préférence, une puce de type N d'une première jonction du premier groupe est connectée en série avec un puce de type P d'une première jonction du second groupe et en ce qu'une puce de type P de la première jonction du premier groupe est connectée en série avec une puce de type N d'une seconde jonction du second groupe.

Selon un autre mode de développement de l'invention, une puce de type N d'au moins une première jonction du premier groupe est connectée en parallèle avec une puce de type N d'au moins une première jonction du second groupe et en ce qu'une puce de type P de ladite au moins une première jonction du premier groupe est connectée en parallèle avec une puce de type P de ladite au moins une première jonction du second groupe pour augmenter l'intensité du courant.

Avantageusement, l'isolant thermique séparant les deux groupes de jonctions est l'air permettant de maintenir l'écart de température existant entre la première et seconde température.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
- la figure 1 représente une vue schématique de module thermoélectrique selon un mode connu de réalisation ;
- la figure 2 représente une vue schématique d'un module thermoélectrique selon un premier mode préférentiel de réalisation de l'invention ;
- la figure 3 représente une vue schématique d'un module thermoélectrique selon un second mode préférentiel de réalisation de l'invention.

### DESCRIPTION DETAILLEE D'UN MODE DE REALISATION

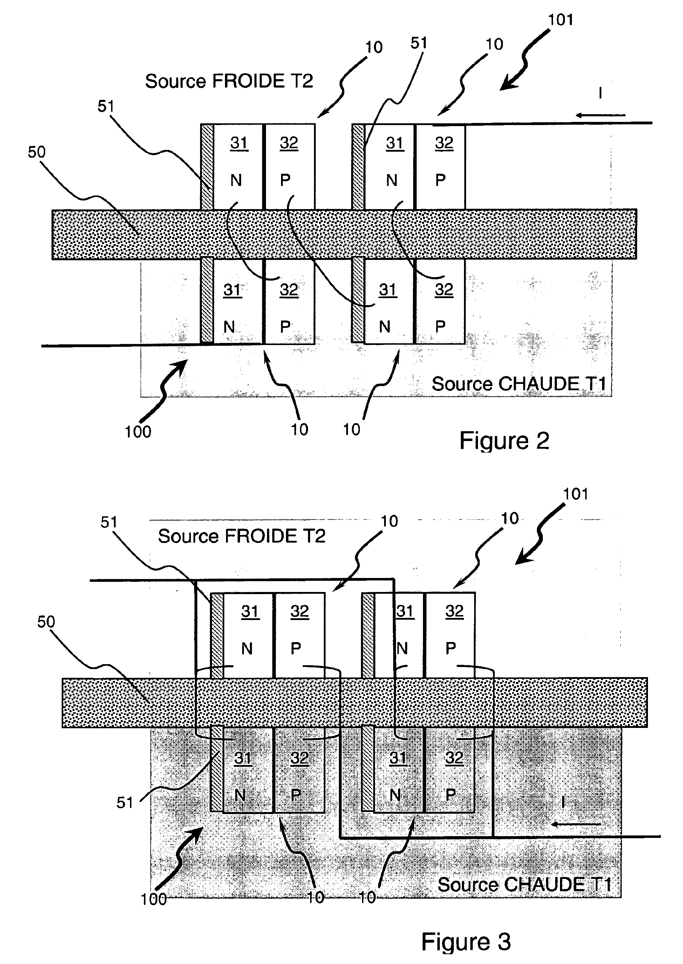

Selon les modes de réalisation tel que représenté sur les figures 2 et 3, le module thermoélectrique comprend une matrice délimitée par deux faces et comportant des jonctions 10 ayant respectivement deux puces thermoélectriques 31, 32 de type N et de type P Lesdites jonctions sont reliées électriquement pour former un circuit électrique.

Les jonctions 10 sont reliées électriquement les unes aux autre de manière à ce que la circulation d'un courant électrique I dans une direction sélectionnée chauffe ou refroidisse l'une des faces de la matrice grâce à un effet Peltier créé au niveau des puces. En outre, le chauffage ou le refroidissement d'une des faces de la matrice fait circuler un courant électrique dans une direction donnée grâce à un effet Seebeck créé au niveau des puces ;

Selon les modes de réalisation de l'invention, le module thermoélectrique comprend un premier groupe 100 comprend au moins une jonction 10 de deux puces thermoélectriques 31, 32 de type N et de type P. Ledit premier groupe de jonctions est exposé à une première température de fonctionnement T1. Un second groupe 101 comprend au moins une jonction 10 de deux puces thermoélectriques 31, 32 de type P et de type N. Le second groupe de jonctions est exposé à une seconde température de fonctionnement T2. La seconde température T2 est inférieure à la première température T1. A titre d'exemple de réalisation, la première température T1 peut atteindre une valeur de -10°C et la seconde température T2 peut atteindre un température de 140°C.

Les deux groupes de jonctions sont séparés l'un de l'autre par un isolant thermique 50 permettant de maintenir l'écart de température existant entre T1 et T2. A titre d'exemple de réalisation, l'isolant thermique 50 séparant les deux groupes de jonctions 101, 101 est de préférence l'air. Selon des variantes de réalisation, l'isolant thermique peut être constitué d'une céramique isolante à base par exemple d'alumine, de cordiérite. L'isolant peut aussi être constitué d'un polymère isolant résistant aux températures d'utilisation.

A titre d'exemple de réalisation tel que représenté sur les figures 2 et 3, chaque groupe de jonction 100, 101 comporte respectivement deux jonctions 10. Le nombre de jonctions 10 ainsi que leur connections (série et parallèle) est déterminé en fonction de la puissance à fournir par le module thermo générateur

Selon un premier mode préférentiel de réalisation de l'invention tel que représenté sur la figure 2, le module thermoélectrique comporte au moins une puce 31 de type N d'une première jonction 10 du premier groupe 100 connectée en série avec un puce 32 de type P d'une première jonction 10 du second groupe 101. Selon ce mode de réalisation, cette configuration permet d'augmenter la tension aux bornes du module thermoélectrique. A titre d'exemple de réalisation, une puce 31 de type N d'une première jonction 10 du premier groupe est connectée en série avec un puce 32 de type P d'une première jonction 10 du second groupe 101. En outre, une puce 32 de type P de la première jonction 10 du premier groupe 100 est connectées en série avec une puce 31 de type N d'une seconde jonction 10 du second groupe 101.

Selon un second mode préférentiel de réalisation de l'invention tel que représenté sur la figure 3, le module thermoélectrique comporte une puce 31 de type N d'au moins une première jonction 10 du premier groupe 101 connectée en parallèle avec une puce 31 de type N d'au moins une première jonction du second groupe 101. En outre, une puce 32 de type P de ladite au moins une première jonction du premier groupe est connectées en parallèle avec une puce 32 de type P de ladite au moins une première jonction du second groupe. Selon ce mode de réalisation, cette configuration permet d'augmenter l'intensité du courant.

Selon un mode de réalisation de l'invention, les deux puces 31, 32 de type N et P d'une jonction 10 sont de forme aplanie pour être empilées sur un substrat isolant 51.

De préférence les jonctions 10 sont réalisées par des dépôts de couches minces sur un substrat isolant. Les dépôts peuvent alors être notamment réalisés en phase vapeur et en phase solide (PVD : physical vapor deposition). Les dépôts peuvent aussi être réalisés notamment par voix chimique (CVD : chemical vapor deposition). Enfin les dépôts de couches minces peuvent être réalisés par des technique d'impression jet d'encre, ou par dépôt par voie humide

De préférence les jonctions 10 sont réalisées par laminage de couches épaisses sur un substrat isolant.

## Revendications

1. Module thermoélectrique comprenant une matrice comportant des jonctions (10) ayant respectivement deux puces thermoélectriques (31, 32) de type N et de type P, lesdites jonctions étant reliées électriquement pour former un circuit électrique de manière à ce que :
- la circulation d'un courant électrique (I) dans une direction sélectionnée chauffe ou refroidisse l'une des faces de la matrice grâce à un effet Peltier créé au niveau des puces ;
- le chauffage ou le refroidissement d'une des faces de la matrice fait circuler un courant électrique dans une direction donnée grâce à un effet Seebeck créé au niveau des puces ;
module **caractérisé en ce qu'**il comprend un premier et second groupes de jonctions (101, 101) séparés l'un de l'autre par un isolant thermique (50), le premier groupe (100) comprenant au moins une jonction (10) de deux puces thermoélectriques (31, 32) de type N et de type P et le second groupe (101) comprenant au moins une jonction (10) de deux puces thermoélectriques (31, 32) de type N et de type P, les premier et second groupes de jonctions étant exposés respectivement à une première et à une seconde température de fonctionnement (T1, T2),
- les deux puces (31, 32) de type N et P d'une jonction (10) étant de forme aplanie pour être empilées sur un substrat isolant (51) par dépôt de couches minces sur un substrat isolant;
- au moins une puce (31) de type N d'une première jonction (10) du premier groupe (100) étant connectée électriquement avec une puce (31, 32) de type P ou de type N d'une première jonction (10) du second groupe (101).

2. Module thermoélectrique selon la revendication 1 **caractérisé en ce que** au moins une puce (31) de type N d'une première jonction (10) du premier groupe (100) est connectée en série avec une puce (32) de type P d'une première jonction (10) du second groupe (101) pour augmenter la tension.

3. Module thermoélectrique selon la revendication 2 **caractérisé en ce que** une puce (31) de type N d'une première jonction (10) du premier groupe (100) est connectée en série avec une puce (32) de type P d'une première jonction (10) du second groupe (101) et **en ce qu'**une puce (32) de type P de la première jonction (10) du premier groupe (100) est connectée en série avec une puce (31) de type N d'une seconde jonction (10) du second groupe (101).

4. Module thermoélectrique selon la revendication 1 **caractérisé en ce que** une puce (31) de type N d'au moins une première jonction (10) du premier groupe (100) est connectée en parallèle avec une puce (31) de type N d'au moins une première jonction du second groupe et **en ce qu'**une puce (32) de type P de ladite au moins une première jonction du premier groupe est connectées en parallèle avec un puce (32) de type P de ladite au moins une première jonction du second groupe pour augmenter l'intensité du courant.

5. Module thermoélectrique selon l'une quelconque des revendications précédentes, **caractérisé en ce que** l'isolant thermique (50) séparant les deux groupes de jonctions (101, 101) est l'air permettant de maintenir l'écart de température existant entre la première et seconde température de fonctionnement (T1, T2).
